# EUROPEAN PATENT APPLICATION

(11) **EP 3 617 340 A1**
(43) Date of publication of application: **04.03.2020**
(21) Application number: 17907920.7
(22) Date of filing: 24.11.2017
(51) Int. Cl.: C23C 14/04, C23C 14/24

(54) **MASK SHEET, MASK PLATE AND ASSEMBLY METHOD THEREFOR**

(30) Priority: 27.04.2017 CN 201710289649
(71) Applicant: BOE Technology Group Co., Ltd., Beijing 100015 (CN); Ordos Yuansheng Optoelectronics Co., Ltd., Ordos, Inner Mongolia 017020 (CN)
(72) Inventor: JIN, Long, Beijing 100176 (CN); HUANG, Chun Chieh, Beijing 100176 (CN); TANG, Fuqiang, Beijing 100176 (CN); CAO, Fei, Beijing 100176 (CN); WU, Wenze, Beijing 100176 (CN)
(74) Representative: Klunker IP Patentanwälte PartG mbB
(86) International application number: PCT/CN2017/112910
(87) International publication number: WO 2018/196365

(57) **Abstract**

A mask sheet (10, 200, 300), comprising: a mask region (110, 210, 310) and a peripheral region (120, 220, 320) which surrounds the mask region (110, 210, 310); the mask sheet is located at at least one edge portion of the peripheral region (120, 220, 320) comprising a thickness reduction portion (125). Further disclosed are a mask plate and a method for use in assembling the mask plate.

## Description

### CROSS-REFERENCE TO RELATED APPLICATIONS

The application claims priority to the Chinese patent application No. 201710289649.3, filed on April 27, 2017, the entire disclosure of which is incorporated herein by reference as part of the present application.

### TECHNICAL FIELD

Embodiments of the present disclosure relate to a mask sheet, a mask plate, and an assembling method thereof.

### BACKGROUND

With the continuous development of display technologies, conventional displays include liquid crystal displays (LCDs), organic light emitting diodes (OLEDs), plasma display panels (PDPs), and electronic ink displays etc. Organic electroluminescent displays are increasingly welcomed by the market due to their advantages of low power consumption, light weight and thin thickness, high color gamut, high display brightness, wide viewing angle, and fast response speed.

The fine metal mask (FMM) is assembled by welding a frame, a cover, a support bar (howling), and a fine metal mask sheet (FMM Sheet) together. A fine metal mask sheet is a mask sheet that allows a deposition material or an evaporation material to be deposited or evaporated on a substrate and to form a fine pattern. In general, an FMM sheet includes a plurality of openings, such as a plurality of square slits or a plurality of stripe-shaped slits, allowing a deposition material to pass through, so as to deposit or evaporate the deposition or evaporation material onto a substrate to form a fine pattern.

### SUMMARY

At least one embodiment of the present disclosure provides a mask sheet, a mask plate, and an assembling method thereof. The mask sheet is a new type of mask sheet, so that the mask plate using the mask sheet does not need to be provided with a cover, thereby reducing tact time of welding of an entire of the mask plate, and improving assembling efficiency of the mask plate.

At least one embodiment of the present disclosure provides a mask sheet, including: a mask region; and a peripheral region surrounding the mask region, wherein, at least one edge portion of the mask sheet located in the peripheral region includes a thickness reduced portion.

For example, in the mask sheet provided by an embodiment of the present disclosure, the mask sheet has an extension direction, and the at least one edge portion includes a first edge portion and a second edge portion which extend along the extension direction, the first edge portion and the second edge portion include the thickness reduced portion, respectively.

For example, in the mask sheet provided by an embodiment of the present disclosure, the thickness reduced portion includes an upper thickness reduced portion or a lower thickness reduced portion, and the upper thickness reduced portion is obtained by removing a part of the mask sheet in thickness from an upper surface of the mask sheet, and the lower thickness reduced portion is obtained by removing a part of the mask sheet in thickness from a lower surface of the mask sheet.

For example, in the mask sheet provided by an embodiment of the present disclosure, a cross-section of the thickness reduced portion includes a step shape or a trapezoidal shape.

For example, in the mask sheet provided by an embodiment of the present disclosure, the thickness reduced portion includes an intermediate thinned portion or a two-side thinned portion, and the intermediate thinned portion is obtained by removing a part of the mask sheet in thickness between an upper surface and a lower surface of the mask sheet, the two-side thinned portion is obtained by simultaneously removing a part of the thickness of the mask sheet in thickness from an upper surface and a lower surface of the mask sheet.

At least one embodiment of the present disclosure provides mask plate, including: a first mask sheet, including a first mask region and a first peripheral region surrounding the first mask region, at least one edge portion of the first mask sheet in the first peripheral region including an upper thickness reduced portion; and a second mask sheet, including a second mask region and a second peripheral region surrounding the second mask region, at least one edge portion of the second mask sheet in the second peripheral region including a lower thickness reduced portion; wherein, the first mask sheet and the second mask sheet are alternately disposed, and the upper thickness reduced portion and the lower thickness reduced portion of adjacent first mask sheet and second mask sheet are at least partially overlapped with each other.

For example, in the mask plate provided by an embodiment of the present disclosure, the first mask sheet has a first extension direction, and the first mask sheet includes a first edge portion and a second edge portion which are located in the first peripheral region and extend along the first extension direction, the first edge portion and the second edge portion each include the upper thickness reduced portion; the second mask sheet has a second extension direction, and the second mask sheet includes a third edge portion and a fourth edge portion which are located in the second peripheral region and extend along the second extension direction, the third edge portion and the fourth edge portion each include the lower thickness reduced portion.

For example, in the mask plate provided by an embodiment of the present disclosure, a thickness of the first peripheral region and a thickness of the second peripheral region are substantially the same, an overall thickness of the upper thickness reduced portion and the lower thickness reduced portion which are overlapped with each other is substantially the same as the thickness of the first peripheral region and/or the second peripheral region.

For example, in the mask plate provided by an embodiment of the present disclosure, a cross-section of the upper thickness reduced portion and the lower thickness reduced portion includes a step shape or a trapezoidal shape.

For example, in the mask plate provided by an embodiment of the present disclosure, the mask plate further includes: a frame, including an opening; and a plurality of support bars, both ends of each of the plurality of support bars being fixed on the frame; wherein, the first mask sheet and the second mask sheet are alternately arranged on the plurality of support bars and fixedly arranged on the frame to completely cover the opening.

For example, in the mask plate provided by an embodiment of the present disclosure, an orthographic projection of the plurality of support bars on the first mask sheet falls into the first peripheral region of the first mask sheet, an orthographic projection of the plurality of support bars on the second mask sheet falls into the second peripheral region of the second mask sheet.

For example, in the mask plate provided by an embodiment of the present disclosure, the frame includes a support bar mounting surface, and both ends of each of the plurality of the support bars are fixedly disposed on the support bar mounting surface.

For example, in the mask plate provided by an embodiment of the present disclosure, the first extension direction and the second extension direction are substantially perpendicular to a third extension direction of the plurality of support bars.

For example, in the mask plate provided by an embodiment of the present disclosure, the mask plate is not provided with a cover extending along the first extension direction and between adjacent first mask sheet and the second mask sheet.

At least one embodiment of the present disclosure provides an assembling method of a mask plate, the mask plate including: a first mask sheet, including a first mask region and a first peripheral region surrounding the first mask region, at least one edge portion of the first mask sheet in the first peripheral region including an upper thickness reduced portion; and a second mask sheet, including a second mask region and a second peripheral region surrounding the second mask region, at least one edge portion of the second mask sheet in the second peripheral region including a lower thickness reduced portion; and the assembling method includes: mounting the first mask sheet at intervals; and mounting the second mask sheet beside the first mask sheet, and the lower thickness reduced portion of the second mask sheet at least partially covers the upper thickness reduced portion of the first mask sheet.

For example, in the assembling method of the mask plate provided by an embodiment of the present disclosure, the mask plate further including a frame and a plurality of support bars, the frame including an opening, and the assembling method further including: fixedly mounting both ends of each of the support bars on the frame; and alternately mounting the first mask sheet and the second mask sheet on the support bar, and fixing the first mask sheet and the second mask sheet on the frame to completely cover the opening.

For example, in the assembling method of the mask plate provided by an embodiment of the present disclosure, the frame further including a support bar mounting surface, and the assembling method further including: according to a position of the first mask region of the first mask sheet and a position of the second mask region of the second mask sheet, mounting the plurality of support bars so that an orthographic projection of the plurality of support bars on the first mask sheet falls into the first peripheral region, and an orthographic projection of the plurality of support bars on the second mask sheet falls into the second peripheral region.

For example, in the assembling method of the mask plate provided by an embodiment of the present disclosure, mounting the first mask sheet at intervals including: mounting the first mask sheet sequentially from a middle of the frame to two sides of the frame.

### BRIEF DESCRIPTION OF THE DRAWINGS

In order to clearly illustrate the technical solution of the embodiments of the disclosure, the drawings of the embodiments will be briefly described in the following; it is obvious that the described drawings are only related to some embodiments of the disclosure and thus are not limitative of the disclosure.
FIG. 1 is a schematic plan view of a mask plate;
FIG. 2 is a schematic plan view of a mask sheet provided by an embodiment of the present disclosure;
FIG. 3A is a schematic plan view of another mask sheet provided by an embodiment of the present disclosure;
FIG. 3B is a schematic side view of a mask sheet provided by an embodiment of the present disclosure;
FIG. 3C is a schematic side view of another mask sheet provided by an embodiment of the present disclosure;
FIG. 3D is a schematic side view of another mask sheet provided by an embodiment of the present disclosure;
FIG. 4 is a schematic plan view of another mask sheet provided by an embodiment of the present disclosure;
FIG. 5 is a schematic plan view of another mask sheet provided by an embodiment of the present disclosure;
FIG. 6 is a schematic cross-sectional view of a thickness reduced portion provided by an embodiment of the present disclosure;
FIG. 7 is a schematic cross-sectional view of another thickness reduced portion provided by an embodiment of the present disclosure;
FIG. 8 is a schematic plan view illustrating a part of a mask plate according to an embodiment of the present disclosure;
FIG. 9 is a schematic plan view illustrating a part of another mask plate provided by an embodiment of the present disclosure;
FIG. 10 is a schematic plan view of a mask plate provided by an embodiment of the present disclosure;
FIG. 11 is a schematic diagram of a support bar mounting surface according to an embodiment of the present disclosure; and
FIG. 12 is a flowchart of an assembling method of a mask plate provided by an embodiment of the present disclosure.

### DETAILED DESCRIPTION

In order to make objects, technical details and advantages of the embodiments of the disclosure apparent, the technical solutions of the embodiments will be described in a clearly and fully understandable way in connection with the drawings related to the embodiments of the disclosure. Apparently, the described embodiments are just a part but not all of the embodiments of the disclosure. Based on the described embodiments herein, those skilled in the art can obtain other embodiment(s), without any inventive work, which should be within the scope of the disclosure.

Unless otherwise defined, all the technical and scientific terms used herein have the same meanings as commonly understood by one of ordinary skill in the art to which the present disclosure belongs. The terms "first," "second," etc., which are used in the disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. The phrases "connect", "connected", etc., are not intended to limit to a physical connection or mechanical connection, but may include an electrical connection, directly or indirectly.

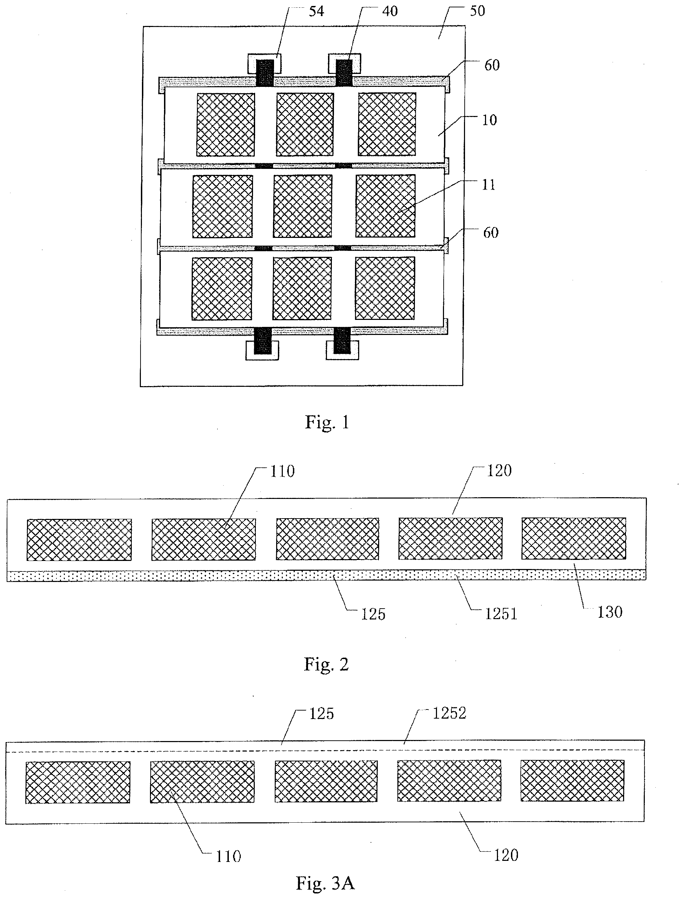

FIG. 1 illustrates a schematic plan view of a mask plate. As illustrated in FIG. 1, the mask plate includes a frame 50, a cover 60, a support bar 40, and a plurality of mask sheets 10. The mask sheet 10 includes at least one mask pattern 11. The frame 50 is provided with a groove 54. The support bar 40 is welded in the groove 54. The plurality of mask sheets 10 are welded on the frame 50. The cover 60 is at least disposed between adjacent mask sheets 10 to prevent a deposition or evaporation material from being deposited or evaporated in a region between adjacent mask sheets 10. In the study, the inventor(s) of the present application found that during the welding process, a position of the cover and the support bar relative to the frame is fixed, so that each frame can only correspond to a welding of one type of mask plate. Therefore, such a mask plate largely reduces the utilization rate of the frame, and results in an increase of the tact time of welding an entire of the mask plate. In addition, because the cover is provided between the substrate (for example, a glass substrate) to be deposited or evaporated and the mask sheet, a distance between the mask sheet and the substrate to be deposited or evaporated is large. That is, a degree of attachment between the mask sheet and the substrate to be deposited or evaporated is low, and accuracy of a pattern to be deposited or evaporated onto the substrate is relatively low.

The embodiments of the present disclosure provide a mask sheet, a mask plate, and an assembling method thereof. The mask sheet includes at least one mask region and a peripheral region surrounding the mask region; at least one edge portion of the mask sheet in the peripheral region includes a thickness reduced portion. Thus, the mask sheet provides a new type of mask sheet, so that the mask plate using the mask sheet does not need to be provided with a cover, thereby reducing tact time of welding an entire of the mask sheet, and improving assembling efficiency of the mask plate. In addition, in the mask plate using the mask sheet, the degree of direct attachment of adjacent mask sheets is relatively high, and the accuracy of the product can be improved.

Hereinafter, the mask sheet, the mask plate and the assembling thereof provided in an embodiment of the present disclosure will be described with reference to the accompanying drawings.

An embodiment of the present disclosure provides a mask sheet. FIG. 2 illustrates a mask sheet according to an embodiment of the present embodiment. The mask sheet includes a mask region 110 and a peripheral region 120 surrounding the mask region 110. At least one edge portion of the mask sheet in the peripheral region 120 includes a thickness reduced portion 125. For example, as illustrated in FIG. 2, the mask sheet includes five mask regions 110 and a peripheral region 120 surrounding the mask regions 110. An edge portion of the mask sheet in the peripheral region 120 includes a thickness reduced portion 125. It should be noted that, the number of mask regions is not limited in the embodiment of the present disclosure, and the number of mask regions can be set according to actual conditions. In addition, the mask region refers to a region having a deposition or evaporation pattern, for example, the mask region includes a plurality of openings, such as a plurality of square slits or a plurality of stripe-shaped slits, allowing the deposition or evaporation material to pass through.

In the mask sheet provided in the present embodiment, at least one edge portion of the mask sheet located in the peripheral region includes a thickness reduced portion. Thus, in the mask plate using the mask sheet, the thickness reduced portions of adjacent mask sheets can be at least partially overlapped with each other, so that the overlapped thickness reduced portions can function as a cover, i.e., to prevent a deposition or evaporation material from being deposited or evaporated in a region between adjacent mask sheets. Therefore, the mask plate using the mask sheet can be not provided with a cover, on the one hand, cost of the mask plate can be reduced, on the other hand, overall welding tact time of the mask plate can be reduced, and assembling efficiency of the mask plate can be improved. In addition, because the mask plate using the mask sheet can be not provided with a cover, a distance between the mask sheet and the substrate to be deposited or evaporated can be set small, that is, a degree of attachment of the mask sheet and the substrate to be deposited or evaporated can be set high, so that accuracy of the pattern deposited or evaporated onto the substrate to be deposited or evaporated can be improved.

For example, in the mask sheet provided in an example of the present embodiment, as illustrated in FIG. 2, the thickness reduced portion 125 is an upper thickness reduced portion 1251. The upper thickness reduced portion 1251 is obtained by removing a part of the mask sheet in thickness from an upper surface 130 of the mask sheet. That is, the thickness of the upper thickness reduced portion described above is smaller than the thickness of a body of the mask sheet, and a bottom surface of the upper thickness reduced portion is in the same plane as a lower surface of the body of the mask sheet.

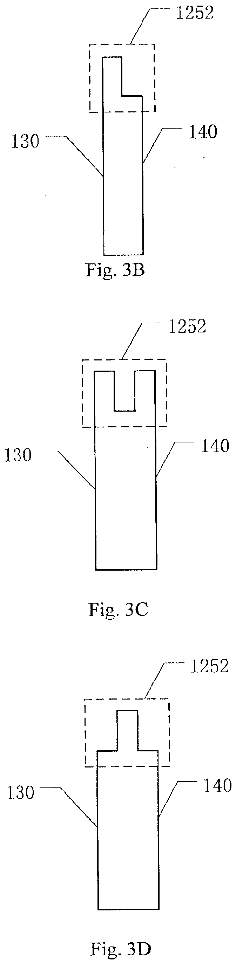

For example, FIG. 3A illustrates a schematic plan view of another mask sheet according to the present embodiment, and FIG. 3B illustrates a schematic side view of the mask sheet illustrated in FIG. 3A. In a mask sheet provided by another example of the present embodiment, the thickness reduced portion 125 can also be a lower thickness reduced portion 1252. As illustrated in FIG. 3B, the lower thickness reduced portion 1252 is obtained by removing a part of the mask sheet in thickness from the lower surface 140 of the mask sheet. That is, a thickness of the lower thickness reduced portion is smaller than the thickness of the body of the mask sheet, and a bottom surface of the lower thickness reduced portion is on the same plane as an upper surface of the body of the mask sheet.

For example, in some examples, the thickness reduced portion can adopt other structures. For example, FIG. 3C illustrates a schematic side view of another mask sheet; FIG. 3D illustrates a schematic side view of another mask sheet. As illustrated in FIGS. 3C and 3D, the thickness reduced portion 125 includes an intermediate thinned portion 1253 or a two-side thinned portion 1254. The intermediate thinned portion 1253 is obtained by removing a part of the mask sheet in thickness between an upper surface 130 and a lower surface 140 of the mask sheet. The two-side thinned portion 1254 is obtained by simultaneously removing a part of the mask sheet in thickness from the upper surface 130 and the lower surface 140 of the mask sheet.

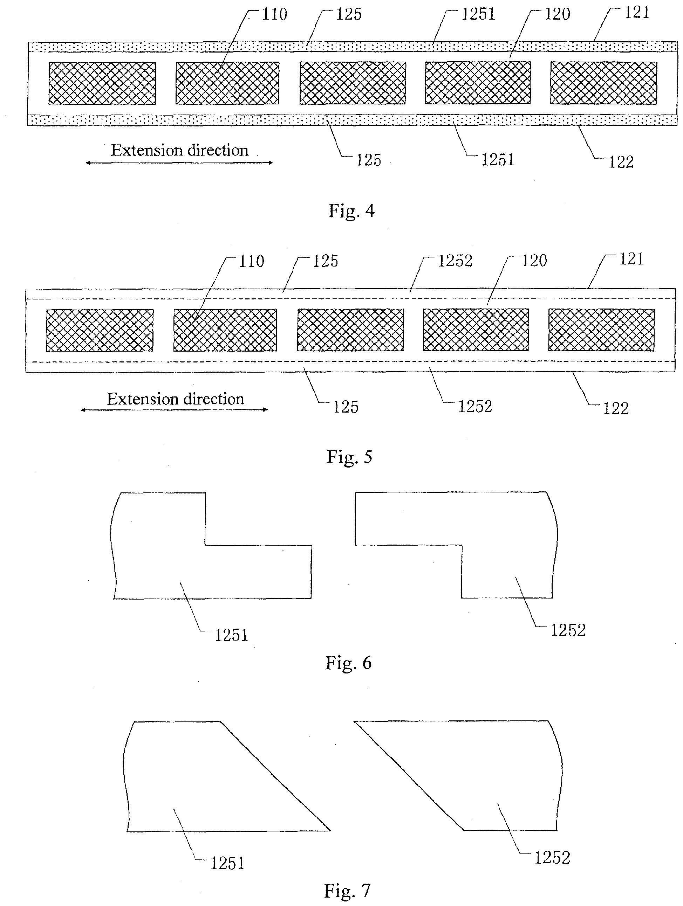

For example, FIG. 4 illustrates a schematic plan view of another mask sheet according to an embodiment. In the mask sheet provided by an example of the present embodiment, the mask sheet has an extension direction, and the mask sheet includes a first edge portion 121 and a second edge portion 122 which extend along the extension direction and are located in the peripheral region 120, i.e., the above-mentioned at least one edge portion, includes a first edge portion 121 and a second edge portion 122 both extending in the extension direction. Both of the first edge portion 121 and the second edge portion 122 include the thickness reduced portion 125 respectively. As a result, the mask sheet can be simultaneously at least partially overlapped with mask sheets on two sides thereof, and the overlapped thickness reduced portions can replace the function of the cover. It should be noted that, the extension direction described above refers to a direction in which the mask sheet elongates or extends in length.

For example, as illustrated in FIG. 4, both of the thickness reduced portions 125 of the first edge portion 121 and the second edge portion 122 of the mask sheet are the upper thickness reduced portions 1251.

For example, FIG. 5 illustrates a schematic plan view of another mask sheet according to an embodiment, both of the thickness reduced portions 125 of the first edge portion 121 and the second edge portion 122 of the mask sheet are the lower thickness reduced portions 1252.

It should be noted that, the above-mentioned thickness reduced portions of the first edge portion and the second edge portion of the mask sheet illustrated in FIGS. 4 and 5 are thickness reduced portion with the same type, that is, the upper thickness reduced portion or the lower thickness portion, which allows easy mounting and welding. Of course, the embodiments of the present disclosure include, but are not limited thereto. The thickness reduced portions of the first edge portion and the second edge portion of the mask sheet can also be thickness reduced portions of different types.

For example, FIG. 6 illustrates a schematic cross-sectional view of a thickness reduced portion according to another embodiment. The left side of FIG. 6 illustrates an upper thickness reduced portion, and the right side of FIG. 6 illustrates a lower thickness reduced portion. As illustrated in FIG. 6, cross-section of the upper thickness reduced portion 1251 and the lower thickness reduced portion 1252 can be a step shape respectively. That is, the thickness reduced portion can be partially thinned in thickness.

For example, FIG. 7 illustrates a schematic cross-sectional view of a thickness reduced portion according to another embodiment of the present embodiment. The left side of FIG. 7 illustrates an upper thickness reduced portion, and the right side of in FIG. 7 illustrates a lower thickness reduced portion. As illustrated in FIG. 7, a cross-section of the upper thickness thinned 1251 and the lower thickness reduced portion 1252 can be a trapezoidal shape respectively.

It should be noted that, the shape of the cross-section of the thickness reduced portion provided by the embodiments of the disclosure includes but is not limited to the above-mentioned shapes illustrated in FIGS. 6 and 7.

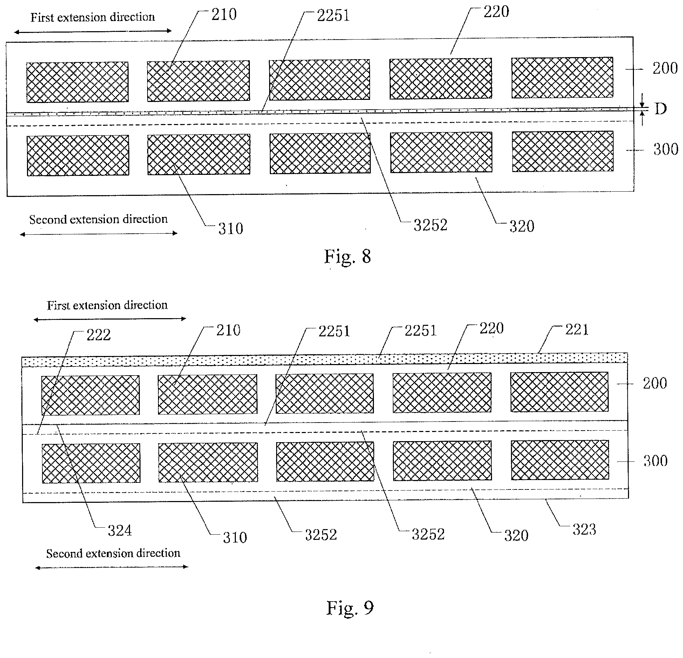

An embodiment of the present disclosure further provides a mask plate. FIG. 8 illustrates a schematic plan view of a part of a mask plate according to an embodiment. The mask plate includes a first mask sheet 200 and a second mask sheet 300. The first mask sheet 200 includes at least one first mask region 210 and a first peripheral region 220 surrounding the first mask region 210. At least one edge portion of the first mask sheet 200 located in the first peripheral region 220 includes an upper thickness portion 2251. The second mask sheet 300 includes at least one second mask region 310 and a second peripheral region 320 surrounding the second mask region 310. At least one edge portion of the second mask sheet 300 located in the second peripheral region 320 includes a lower thickness reduced portion 3252. The first mask sheets 200 and the second mask sheets 300 are alternately disposed, and the upper thickness reduced portion 2251 and the lower thickness reduced portion 3252 of adjacent first mask sheet 200 and second mask sheet 300 are at least partially overlapped with each other.

In the mask plate provided in the present embodiment, at least one edge portion of the first mask sheet in the first peripheral region includes an upper thickness reduced portion, at least one edge portion of the second mask sheet in the second peripheral region includes a lower thickness reduced portion, and the upper thickness reduced portion and the lower thickness reduced portion which belong to adjacent first mask sheet and second mask sheet respectively are at least partially overlapped with each other. Thus, where the upper thickness reduced portion and the lower thickness reduced portion are at least partially overlapped of the adjacent first and second mask sheets can serve as a cover, i.e., to prevent a deposition or evaporation material from being deposited or evaporated in a region (gap) between adjacent first and second mask sheets. Therefore, the mask plate can be not provided with a cover. On the one hand, cost of the mask plate can be reduced. On the other hand, overall welding tact time of the mask plate can be reduced, and assembling efficiency of the mask plate can be improved. In addition, because the mask plate is not provided with a cover, a distance between the first/second mask sheets and the substrate to be deposited or evaporated can be set small, that is to say, a degree of attachment of the first/second mask sheets and the substrate to be deposited or evaporated can be set higher, thereby improving accuracy of a pattern deposited or evaporated on the substrate to be deposited or evaporated.

For example, in the mask plate provided by an example of the present embodiment, as illustrated in FIG. 8, the mask plate includes a first mask sheet 200 and a second mask sheet 300. In this case, an edge portion of the first mask sheet 200 in the first peripheral region 220 and away from the second mask sheet 300 can be not provided with an upper thinned portion, and an edge portion of the second mask sheet 300 in the second peripheral region 320 and away from the first mask sheet 200 can be not provided with the lower thickness reduced portion. Of course, embodiments of the present disclosure include, but are not limited thereto, the first peripheral region of the first mask sheet can be provided with an upper thickness reduced portion at an edge portion away from the second mask sheet, and similarly, the second peripheral region of the second mask sheet can also be provided a lower thickness reduced portion at an edge portion away from the first mask sheet.

It should be noted that, a case that the upper thickness reduced portion and the lower thickness reduced portion of adjacent first mask sheet and second mask sheet are at least partially overlapped includes a case that the upper thickness reduced portion and the lower thickness reduced portion are completely overlapped, and also includes a case that the upper thickness reduced portion and the lower thickness reduced portion are not completely overlapped, as long as the overlapped upper and lower thickness reduced portions can play a role of preventing a deposition or evaporation material from being deposited or evaporated in the region (gap) between adjacent first mask sheet and second mask sheet. For example, as illustrated in FIG. 8, the upper thickness reduced portion 2251 of the first mask sheet 200 and the lower thickness reduced portion 3252 of the second mask sheet 300 are partially overlapped, so that there is a spacing D between the lower thickness reduced portion 3252 and a portion of the first peripheral region 220 where is not thickness thinned.

FIG. 9 illustrates a schematic plan view of a part of another mask plate according to the present embodiment. As illustrated in FIG. 9, in the mask plate, the upper thickness reduced portion 2251 of the first mask sheet 200 and the lower thickness reduced portion 3252 of the second mask sheet 300 are completely overlapped, and thus, the lower thickness reduced portion 3252 is in contact with a portion of the first peripheral region 220 where is not thickness thinned.

For example, in the mask plate provided in an example of the present embodiment, as illustrated in FIG. 9, the first mask sheet 200 has a first extension direction, and the first mask sheet 200 includes a first edge portion 221 and a second edge portion 222 which are located in the first peripheral region 220 and extend along the first extension direction. The first edge portion 221 and the second edge portion 222 include an upper thickness reduced portion 2251 respectively. The second mask sheet 300 has a second extension direction, and the second mask plate 300 includes a third edge portion 323 and a fourth edge portion 324 which are located in the second peripheral region 320 and extend along the second extension direction. The third edge portion 323 and the fourth edge portion 324 include a lower thickness reduced portion 3252 respectively. Thus, the mask plate can be provided with any number of first mask sheets and second mask sheets alternately disposed, so that different sized mask plates can be formed. It should be noted that, the above-mentioned first extension direction refers to a direction in which the first mask sheet elongates or extends in length, and the above-mentioned second extension direction refers to a direction in which the second mask sheet elongates or extends in length. The first extension direction and the second extension direction can be the same direction.

For example, in the mask plate provided by an example of the present embodiment, a thickness of the first peripheral region of the first mask sheet and a thickness of the second peripheral region of the second mask sheet are substantially the same, and an overall thickness of the upper thickness reduced portion of the first mask sheet and the lower thickness reduced portion of the second mask sheet is substantially the same as a thickness of the first peripheral region or the second peripheral region. Thus, flatness of the first mask sheets and the second mask sheets alternately disposed in the mask plate is high, so that accuracy of a pattern deposited or evaporated on the substrate to be deposited or evaporated can be further improved. It should be noted that, the above-mentioned "thicknesses are substantially the same" refers to that the thicknesses of the two are within 5%.

For example, in the mask plate provided in an example of the present embodiment, the cross-section of the upper and lower thickness reduced portions include a step shape or a trapezoidal shape. For details, reference can be made to the related description in the first embodiment, which will not be repeated herein in the present embodiment.

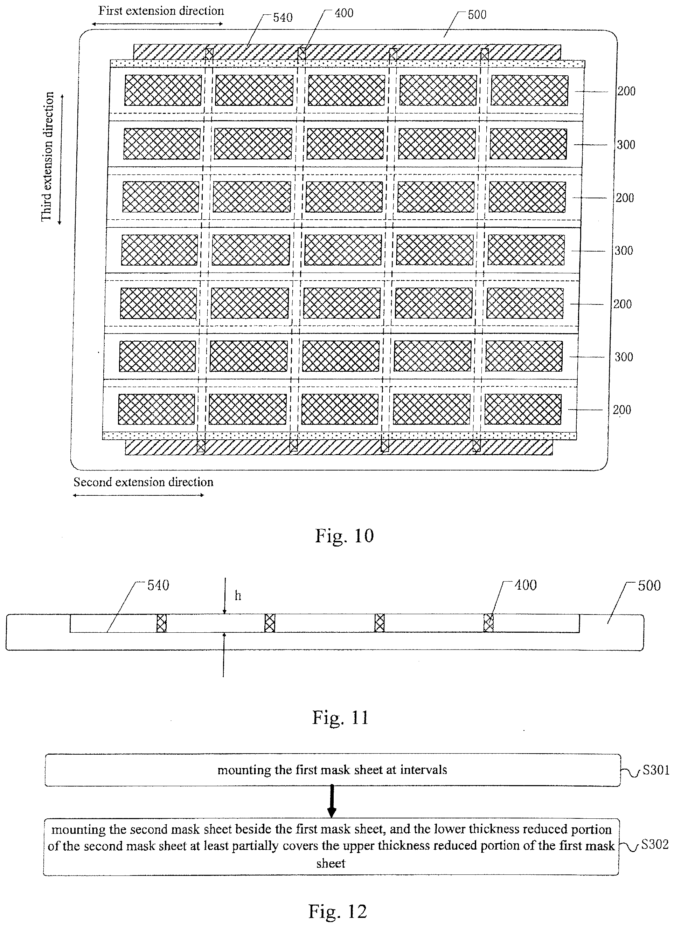

FIG. 10 illustrates a schematic plan view of a mask plate according to an embodiment. As illustrated in FIG. 10, the mask plate further includes a frame 500 having an opening (not illustrated in the figure) and a plurality of support bars 400. Both ends of each of the plurality of support bars 400 are fixed on the frame 500. The first mask sheet 200 and the second mask sheet 300 are alternately and disposed on the support bar 400 and are fixedly disposed on the frame 500 to completely cover the opening. Thus, the first mask sheet and the second mask sheet can be in a tension state on the frame.

For example, in the mask plate provided in an example of the present embodiment, as illustrated in FIG. 10, the support bar 400 has a third extension direction, and the third extension direction is substantially perpendicular to the first extension direction and the second extension direction. It should be noted that, the above-mentioned substantially perpendicular means that an included angle between the two is within 1°.

For example, in the mask plate provided in an example of the present embodiment, as illustrated in FIG. 10, an orthographic projection of the plurality of support bars 400 on the first mask sheet 200 falls into the first peripheral region 220 of the first mask sheet 200; an orthographic projection of the plurality of support bars 400 on the second mask sheet 300 falls into the second peripheral region 320 of the second mask sheet 300. That is, the plurality of support bars 400 plays a role of supporting the first mask sheet 200 and the second mask sheet 300, and does not block the first mask pattern 210 on the first mask sheet 200 and the second mask pattern 310 on the second mask sheet 300.

For example, in the mask plate provided in an example of the present embodiment, the frame 500 includes a support bar mounting surface 540. Two ends of each of the support bars 400 are fixed on the support bar mounting surface 540. Thus, grooves are not provided on the frame for each support bar, and thus, the support bars can be set according to the size and parameters (for example, a position and the number of mask patterns on the mask sheet) of the mask sheet. A frame can be used for assembling of multiple mask plates to increase utilization of the frame.

FIG. 11 illustrates a schematic view of a support bar mounting surface according to an embodiment. As illustrated in FIG. 11, the support bar mounting surface 540 is a surface that is recessed on a surface of the frame 500. A depth H of the support bar mounting surface 540 can be set according to a thickness of the support bar 400, for example, the depth H of the support bar mounting surface 540 is equal to the thickness of the support bar 400. That is, in a case that both ends of the support bar are fixed on the support bar mounting surface, a surface of the support bar and a surface of a body of the frame can be in the same plane. Of course, the depth of the support bar mounting surface can be not set according to the thickness of the support bar, and the embodiment of the present disclosure is not limited herein.

In the mask plate provided in the present embodiment, a cover along the first extension direction and between adjacent first mask sheet and second mask sheet can be not provided (omitted). Thus, on the one hand, cost of the mask plate can be reduced, and on the other hand, overall welding tact time of the mask plate can be reduced, and assembling efficiency of the mask plate can be improved. In addition, because the mask plate is not provided with a cover, a distance between the first mask sheet and the second mask sheet and the substrate to be deposited or evaporated can be set small, that is to say, a degree of attachment of the first/second mask sheets and the substrate to be deposited or evaporated can be set higher, so that accuracy of a pattern deposited or evaporated on the substrate to be deposited or evaporated can be improved.

An embodiment of the present disclosure further provides an assembling method of a mask plate, the mask plate including: a first mask sheet and a second mask sheet, the first mask sheet including a first mask region and a first peripheral region surrounding the first mask region, at least one edge portion of the first mask sheet in the first peripheral region including an upper thickness reduced portion; and the second mask sheet including a second mask region and a second peripheral region surrounding the second mask region, at least one edge portion of the second mask sheet in the second peripheral region including a lower thickness reduced portion; as illustrated in FIG. 12, the assembling method includes step S301 and step S302.

Step S301: mounting the first mask sheets at intervals; and

Step S302: mounting the second mask sheet beside the first mask sheet, and the lower thickness reduced portion of the second mask sheet at least partially covers the upper thickness reduced portion of the first mask sheet.

Thus, the upper and lower thickness reduced portions of adjacent first and second mask sheets are at least partially overlapped. Therefore, the mask plate can be not provided with a cover. On the one hand, cost of the mask plate can be reduced. On the other hand, overall welding tact time of the mask plate can be reduced, and assembling efficiency of the mask plate can be improved. In addition, because the mask plate is not provided with a cover, a distance between the first/second mask sheets and the substrate to be deposited or evaporated can be set small. That is to say, a degree of attachment of the first mask sheet and the second mask sheet and the substrate to be deposited or evaporated can be set high, so that accuracy of a pattern deposited or evaporated on the substrate to be deposited or evaporated can be improved. In addition, because the first mask sheet having the upper thickness reduced portion is provided first, and then the second mask sheet having the lower thickness reduced portion is mounted, the assembling difficulty of the mask plate can be reduced.

For example, in the assembling method of the mask plate provided in an example of the present embodiment, the mask plate further includes a frame and a plurality of support bars, the frame includes an opening, and the assembling method can further include: fixedly mounting two ends of the support bars on the frame; and alternately mounting the first mask sheet and the second mask sheet on the support bar and fixing the first mask sheet and the second mask sheet on the frame to completely cover the opening.

For example, in the assembling method of the mask plate provided in an example of the present embodiment, the frame includes a support bar mounting surface. The assembling method includes: according to a position of the first mask region of the first mask sheet and a position of the second mask region of the second mask sheet, mounting the plurality of support bars so that an orthographic projection of the plurality of support bars on the first mask sheet falls into the first peripheral region of the first mask sheet, and an orthographic projection of the plurality of support bars on the second mask sheet falls into the second peripheral region of the second mask sheet. Thus, on the one hand, the plurality of support bars plays a role of supporting the first mask sheet and the second mask sheet, and does not block the first mask pattern of the first mask sheet and the second mask pattern of the second mask sheet. In addition, the support bars can be set according to the size and parameters (e.g., a position and the number of mask patterns of the mask sheet) of the mask sheet. A frame can be used for assembling of multiple mask plates to increase utilization of the frame.

For example, in the assembling method of the mask plate provided in an example of the present embodiment, mounting the first mask sheets at intervals includes: mounting, such as welding, the first mask sheet at intervals sequentially from a middle of the frame to two sides of the frame.

The following statements should be noted:
(1) The accompanying drawings involve only the structure(s) in connection with the embodiment(s) of the present disclosure, and other structure(s) can be referred to common design(s).
(2) In case of no conflict, features in one embodiment or in different embodiments can be combined.

What have been described above are only specific implementations of the present disclosure, the protection scope of the present disclosure is not limited thereto. Any changes or substitutions easily occur to those skilled in the art within the technical scope of the present disclosure should be covered in the protection scope of the present disclosure. Therefore, the protection scope of the present disclosure should be based on the protection scope of the claims.

## Claims

1. A mask sheet, comprising:
a mask region; and
a peripheral region surrounding the mask region,
wherein at least one edge portion of the mask sheet located in the peripheral region comprises a thickness reduced portion.

2. The mask sheet according to claim 1, wherein the mask sheet has an extension direction, the at least one edge portion comprises a first edge portion and a second edge portion which extend along the extension direction, and the first edge portion and the second edge portion comprise the thickness reduced portion, respectively.

3. The mask sheet according to claim 1 or 2, wherein the thickness reduced portion comprises an upper thickness reduced portion or a lower thickness reduced portion, and the upper thickness reduced portion is obtained by removing a part of the mask sheet in thickness from an upper surface of the mask sheet, and the lower thickness reduced portion is obtained by removing a part of the mask sheet in thickness from a lower surface of the mask sheet.

4. The mask sheet according to claim 1 or 2, wherein a cross-section of the thickness reduced portion comprises a step shape or a trapezoidal shape.

5. The mask sheet according to claim 1 or 2, wherein the thickness reduced portion comprises an intermediate thinned portion or a two-side thinned portion, and the intermediate thinned portion is obtained by removing a part of the mask sheet in thickness between an upper surface and a lower surface of the mask sheet, the two-side thinned portion is obtained by simultaneously removing a part of the mask sheet in thickness from an upper surface and a lower surface of the mask sheet.

6. A mask plate, comprising:
a first mask sheet, comprising a first mask region and a first peripheral region surrounding the first mask region, at least one edge portion of the first mask sheet in the first peripheral region comprising an upper thickness reduced portion; and
a second mask sheet, comprising a second mask region and a second peripheral region surrounding the second mask region, at least one edge portion of the second mask sheet in the second peripheral region comprising a lower thickness reduced portion;
wherein the first mask sheet and the second mask sheet are alternately disposed, and the upper thickness reduced portion and the lower thickness reduced portion of adjacent first mask sheet and second mask sheet are at least partially overlapped with each other.

7. The mask plate according to claim 6, wherein the first mask sheet has a first extension direction, and the first mask sheet comprises a first edge portion and a second edge portion which are located in the first peripheral region and extend along the first extension direction, the first edge portion and the second edge portion each comprise the upper thickness reduced portion;
the second mask sheet has a second extension direction, and the second mask sheet comprises a third edge portion and a fourth edge portion which are located in the second peripheral region and extend along the second extension direction, the third edge portion and the fourth edge portion each comprise the lower thickness reduced portion.

8. The mask plate according to claim 6 or 7, wherein a thickness of the first peripheral region and a thickness of the second peripheral region are substantially the same, an overall thickness of the upper thickness reduced portion and the lower thickness reduced portion which are overlapped with each other is substantially the same as the thickness of the first peripheral region and/or the second peripheral region.

9. The mask plate according to claim 6 or 7, wherein cross-sections of the upper thickness reduced portion and the lower thickness reduced portion comprise a step shape or a trapezoidal shape.

10. The mask plate according to any one of claims 6-9, further comprising:
a frame, comprising an opening; and
a plurality of support bars, both ends of each of the plurality of support bars being fixed on the frame;
wherein the first mask sheet and the second mask sheet are alternately arranged on the plurality of support bars and fixedly arranged on the frame to completely cover the opening.

11. The mask plate according to claim 10, wherein an orthographic projection of the plurality of support bars on the first mask sheet falls into the first peripheral region of the first mask sheet, an orthographic projection of the plurality of support bars on the second mask sheet falls into the second peripheral region of the second mask sheet.

12. The mask plate according to claim 10, wherein the frame comprises a support bar mounting surface, and both ends of each of the plurality of support bars are fixedly disposed on the support bar mounting surface.

13. The mask plate according to claim 10, wherein the first extension direction and the second extension direction are substantially perpendicular to a third extension direction of the plurality of support bars.

14. The mask plate according to any one of claims 6-9, wherein the mask plate is not provided with a cover extending along the first extension direction and between adjacent first mask sheet and the second mask sheet.

15. An assembling method of a mask plate, the mask plate comprising:
a first mask sheet, comprising a first mask region and a first peripheral region surrounding the first mask region, at least one edge portion of the first mask sheet in the first peripheral region comprising an upper thickness reduced portion; and
a second mask sheet, comprising a second mask region and a second peripheral region surrounding the second mask region, at least one edge portion of the second mask sheet in the second peripheral region comprising a lower thickness reduced portion; and the assembling method comprises:
mounting the first mask sheet at intervals; and
mounting the second mask sheet beside the first mask sheet, and the lower thickness reduced portion of the second mask sheet at least partially covers the upper thickness reduced portion of the first mask sheet.

16. The assembling method of the mask plate according to claim 15, the mask plate further comprising a frame and a plurality of support bars, the frame comprising an opening, and the assembling method further comprising:
fixedly mounting both ends of each of the plurality of support bars on the frame; and
alternately mounting the first mask sheet and the second mask sheet on the support bar, and fixing the first mask sheet and the second mask sheet on the frame to completely cover the opening.

17. The assembling method of a mask plate according to claim 16, the frame further comprising a support bar mounting surface, and the assembling method further comprising:
according to a position of the first mask region of the first mask sheet and a position of the second mask region of the second mask sheet, mounting the plurality of support bars so that an orthographic projection of the plurality of support bars on the first mask sheet falls into the first peripheral region, and an orthographic projection of the plurality of support bars on the second mask sheet falls into the second peripheral region.

18. The assembling method of a mask plate according to claim 16 or 17, mounting the first mask sheet at intervals comprising: mounting the first mask sheet sequentially from a middle of the frame to two sides of the frame.
